# EUROPEAN PATENT APPLICATION

(11) **EP 4 130 334 A1**
(43) Date of publication of application: **08.02.2023**
(21) Application number: 21780980.5
(22) Date of filing: 25.03.2021
(51) Int. Cl.: C23C 16/455

(54) **GAS DISTRIBUTOR IN SEMICONDUCTOR DEVICE AND SEMICONDUCTOR DEVICE**

(30) Priority: 03.04.2020 CN 202010258810
(71) Applicant: Beijing NAURA Microelectronics Equipment Co., Ltd., Beijing 100176 (CN)
(72) Inventor: ZHAO, Leichao, Beijing 100176 (CN); SHI, Xiaoping, Beijing 100176 (CN); LAN, Yunfeng, Beijing 100176 (CN); WANG, Yongfei, Beijing 100176 (CN); QIN, Haifeng, Beijing 100176 (CN); ZHANG, Wenqiang, Beijing 100176 (CN); JI, Hong, Beijing 100176 (CN)
(74) Representative: Cohausz & Florack
(86) International application number: PCT/CN2021/082983
(87) International publication number: WO 2021/197200

(57) **Abstract**

The present disclosure provides a gas distributor in a semiconductor apparatus. In a distributor body, a gas outlet end of a first gas inlet pipeline is communicated with a gas inlet of a gas distribution pipeline group, and gas inlet ends of a plurality of first gas outlet pipelines are communicated with a plurality of gas outlets of the gas distribution pipeline group in a one-to-one correspondence. The gas distribution chamber in the above-mentioned distributor body is located above the gas distribution pipeline group and is arranged around the first gas inlet pipeline. A height of the gas distribution chamber gradually decreases from an inner peripheral edge close to the first gas inlet pipeline to an outer peripheral edge away from the first gas inlet pipeline. The gas outlet ends of a second gas inlet pipeline are communicated with a gas inlet of the gas distribution chamber. The gas inlet ends of the plurality of second gas outlet pipelines are communicated with the plurality of gas outlets of the gas distribution chamber in a one-to-one correspondence. The first gas outlet pipelines and the second gas outlet pipelines are arranged alternately. Gas outlet ends of the first gas outlet pipelines and the second gas outlet pipelines are located on a gas outlet end surface of the distributor body. The present disclosure also provides a semiconductor apparatus. With the present disclosure, the uniformity of thin film deposition can be improved.

## Description

### TECHNICAL FIELD

The present disclosure generally relates to the semiconductor technology field and, more particularly, to a semiconductor apparatus and a gas distributor of the semiconductor apparatus.

### BACKGROUND

Atomic layer deposition technology is a thin film preparation technology that is adsorbed layer by layer on a substrate in a form of a single atomic layer. The atomic layer deposition technology mainly includes two reaction processes. A first reaction process includes that a first reaction precursor enters a reaction chamber and is fully adsorbed at the substrate, after reaching a saturated state, a purge gas enters the reaction chamber to remove the remaining reaction precursor and a by-product. A second reaction process includes that a second reaction precursor enters the reaction chamber, reacts with a base group adsorbed at a surface of the substrate, and releases a reaction by-product. After saturated adsorption is formed, the purge gas enters the reaction chamber to remove the remaining reaction precursors and their by-products.

### SUMMARY

The present disclosure is intended to solve at least one of the technical problems in the existing technology and provides a semiconductor apparatus and a gas distributor of the semiconductor apparatus.

In order to achieve the above purpose, the present disclosure provides a gas distributor in a semiconductor apparatus, including a distributor body, the distributor body including a gas outlet end surface, wherein the distributor body includes:
a gas distribution pipeline group, a first gas inlet pipeline, and a plurality of first gas outlet pipeline, wherein a gas outlet end of the first gas inlet pipeline is communicated with a gas inlet of the gas distribution pipeline group, and gas inlet ends of the plurality of first gas outlet pipelines are communicated to a plurality of gas outlets of the gas distribution pipeline group in a one-to-one correspondence. and
the distributor body further includes:
   a gas distribution chamber, a second gas inlet pipeline, and a plurality of second gas outlet pipelines, wherein the gas distribution chamber is located above the gas distribution pipeline group, is arranged surrounding the first gas inlet pipeline, a height of the gas distribution chamber greadually decreases from an inner peripheral edge close to the first gas inlet pipeline to an outer peripheral edge away from the first gas inlet pipeline, a gas outlet of the second gas inlet pipeline is communicated with a gas inlet of the gas distribution chamber, gas inlets of the plurality of second gas outlets are communicated with the gas outlets of the gas distribution chamber in a one-to-one correspondence, the first outlet pipelines and the second outlet pipelines are staggeredly arranged, and the gas outlet ends of the first outlet pipelines and the second outlet pipelines are located on the gas outlet end surface of the distributor body.

In some embodiments, the height of the gas distribution chamber at the inner peripheral edge is between 2 mm and 4 mm, and the height of the gas distribution chamber at the outer peripheral edge is between 0.5 mm and 1 mm.

In some embodiments, the gas distribution pipeline group includes a plurality of main pipelines. The plurality of main pipelines are radially arranged from the first gas inlet pipeline in different directions away from the first gas inlet pipeline. Ends of the plurality of main pipelines close to the first gas inlet pipeline are communicated with a gas outlet end of the first gas inlet pipeline.

The gas distribution pipeline group further includes a plurality of sub-pipeline groups. The sub-pipeline groups are arranged in a one-to-one correspondence with the main pipelines. Each of the sub-pipeline groups includes a plurality of sub-pipelines arranged on two sides of the corresponding main pipeline and at a predetermined included angle with the corresponding main pipeline. A plurality of sub-pipelines of each of the sub-pipeline groups are located on a same side of the main pipeline being arranged at intervals along an extension direction of the main pipeline. An end of each of the sub-pipelines close to the main pipeline is communicated with the main pipeline. A plurality of gas outlets of the gas distribution pipeline group are arranged at the plurality of sub-pipelines.

In some embodiments, the gas distribution pipeline group further includes at least one connection pipeline; and
the connection pipeline is communicated with the main pipeline and/or the sub-pipeline intersecting with an extension trajectory of the connection pipeline.

In some embodiments, each connection pipeline is an annular pipeline. A plurality of annular pipelines are included. Orthographic projections of the plurality of annular pipelines on a radial cross-section of the first gas inlet pipeline have different diameters and are concentrically arranged with an orthographic projection of an axis of the first gas inlet pipeline as a center. A radial distance between orthographic projections of any two neighboring annular pipelines is equal. The gas outlet of each of the sub-pipelines is located at a position where the sub-pipeline intersects with the connection pipeline.

In some embodiments, from an end of the main pipeline close to the first gas inlet pipeline to the other end away from the first gas inlet pipeline, an inner diameter of the main pipeline gradually decreases, and from an end of the sub-pipeline close to the main pipeline to the other end away from the main pipeline, an inner diameter of the sub-pipeline gradually decreases.

In some embodimets, all sub-pipelines located between any two neighboring main pipelines are parallel to each other.

In some embodiments, the sub-pipelines located on the two sides of the main pipeline of a same sub-pipeline group are arranged symmetrically.

In some embodiments, the second gas inlet pipeline is an annular gas inlet pipeline arranged around the first gas inlet pipeline.

Correspondingly, the present disclosure further provides a semiconductor apparatus, including the gas distributor. A gas inlet end of the first gas inlet pipeline is configured to be communicated with the first reaction gas supply device. A gas inlet end of the second gas inlet pipeline is configured to be communicated with the second reaction gas supply device. The first reaction gas supply device is configured to provide a first reaction gas. The second reaction gas supply device is configured to provide a second reaction gas. A diffusion coefficient of the first reaction gas is greater than a diffusion coefficient of the second reaction gas.

In some embodiments, the semiconductor device further includes a gas inlet block arranged on the distributor body. A first transmission channel and a second transmission channel are arranged in the gas inlet block. The first transmission channel is configured to communicate the first gas inlet pipeline with the first reaction gas supply device. The second transmission channel is configured to communicate the second gas inlet pipeline with the second reaction gas supply device.

A first sealing ring and a second sealing ring surrounding the first sealing ring are arranged between the gas inlet block and the distributor body. A connection position between the first transmission channel and the first gas inlet pipeline is located on an inner side of the first sealing ring. A connection position between the second transmission channel and the second gas inlet pipeline is located between the first sealing ring and the second sealing ring.

When the gas distributor in the semiconductor device provided by embodiments of the present disclosure is used to perform thin film deposition, the reaction gas that is easy to diffuse and purge can be introduced into the gas distribution pipeline group from the first gas inlet pipeline. After being distributed by the gas distribution pipeline group, the reaction gas may be output from the first gas outlet pipelines. The reaction gas that is sticky, easy to condense, and difficult to purge may be introduced into the gas distribution chamber from the second gas inlet pipeline. After such reaction gas diffuses in the gas distribution chamber, the reaction gas can be output from the second gas outlet pipelines. Compared with the existing gas distribution pipeline, the gas distribution chamber may be more beneficial for the gas to diffuse, and the residue is not easy to remain, which can avoid the situation that chemical vapor deposition occurs at the gas outlet due to the gas residue in the pipeline in the gas distribution chamber. Thus, the uniformity of the thin film deposited on the substrate may be improved. Meanwhile, by causing the height of the gas distribution chamber to gradually decrease from the inner peripheral edge close to the first gas inlet pipeline to the outer peripheral edge away from the first gas inlet pipeline, the volume of the gas distribution chamber may gradually decrease from inside to outside. Thus, the gas pressure in the gas distribution chamber may be balanced to further help increase the gas diffusion rate. In addition, since the gas distribution chamber is an integral empty chamber, no dead angle position exists. Thus, the residue of the reaction gas is not easy to remain, which facilitates the cleaning of the gas distributor and improves the application lifetime of the gas distributor.

### BRIEF DESCRIPTION OF THE DRAWINGS

The accompanying drawings are used to provide a further understanding of the present disclosure and constitute a part of the specification, and are used to explain the present disclosure together with the following specific embodiments, but do not constitute a limitation of the present disclosure. In the accompanying drawings:
FIG. 1 is a schematic diagram of an atomic layer deposition apparatus according to embodiments of the present disclosure;
FIG. 2 is a schematic diagram showing a gas distribution pipeline in a gas distributor according to embodiments of the present disclosure;
FIG. 3 is a schematic diagram showing a thickness distribution of a film deposited by an existing gas distributor;
FIG. 4 is a schematic top view of the gas distributor according to embodiments of the present disclosure;
FIG. 5 is a schematic cross-section along line A-A' in FIG. 4;
FIG. 6 is a schematic cross-section along line B-B' in FIG. 4;
FIG. 7 is a schematic structural diagram of a gas distribution pipeline according to embodiments of the present disclosure;
FIG. 8 is a schematic diagram of a semiconductor apparatus according to embodiments of the present disclosure; and
FIG. 9 is a schematic diagram of thickness distribution of a film deposited by a semiconductor apparatus according to embodiments of the present disclosure.

### DETAILED DESCRIPTION OF THE EMBODIMENTS

Specific embodiments of the present disclosure are described in detail below with reference to the accompanying drawings. It should be understood that specific embodiments described here are only used to illustrate and explain the present disclosure, but not to limit the present disclosure.

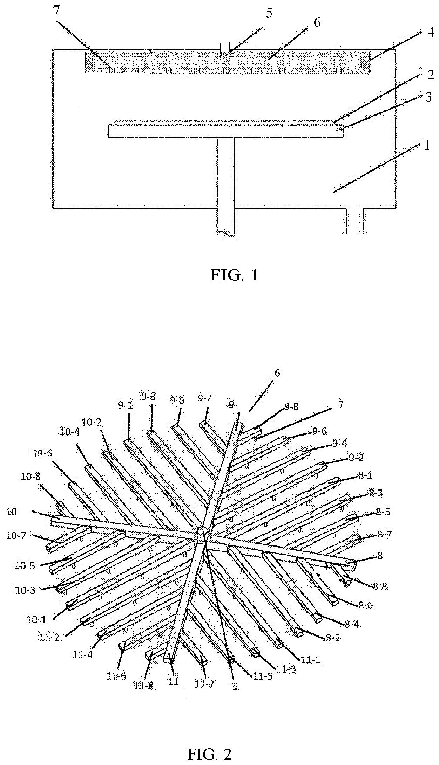

FIG. 1 is a schematic diagram of an atomic layer deposition apparatus according to embodiments of the present disclosure. As shown in FIG. 1, the reaction chamber 1 is provided with a base 3 and a gas distributor 4. A gas distribution pipeline 6 is formed in the gas distributor 4. A specific structure of an existing gas distribution pipeline 6 is shown in FIG. 2. In the gas distribution pipeline 6, inner ends of four main distribution pipelines 8, 9, 10, and 11 are connected together and mutually communicated. Distribution branches are arranged on both sides of each of the main distribution pipelines, including distribution branches 8-1 to 8-8, distribution branches 9-1 to 9-8, distribution branches 10-1 to 10-8, and distribution branches 11-1 to 11-8. As shown in FIG. 1, a plurality of gas outlet pipelines 7 are evenly distributed under the distribution branches. During the atomic layer deposition process, the gas provided by a gas source enters the gas distribution network 6 through the gas inlet pipeline 5, and after diffusing in the gas distribution network 6, is evenly sprayed on the substrate 2 that is to be deposited with the film through the gas outlet pipelines 7.

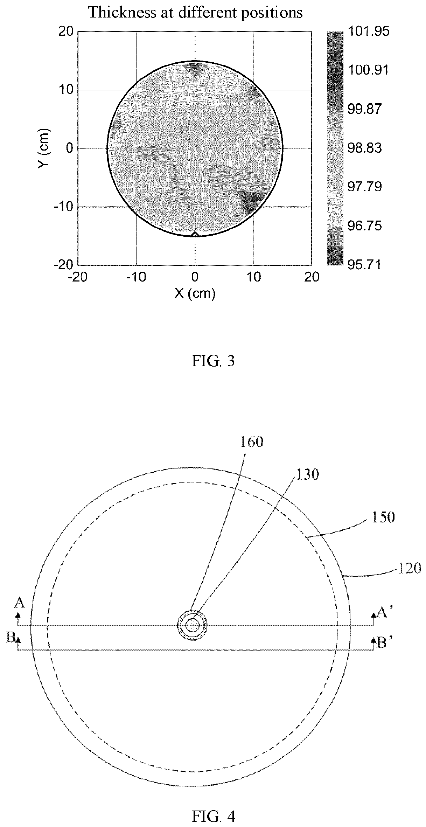

There is also a solution of adopting a gas distributor having two layers of the above-mentioned gas distribution pipelines 6. The double-layered gas distribution pipelines 6 may be configured to transmit two kinds of reaction gases, respectively. The above-mentioned gas distribution pipeline 6 may easily realize rapid transfer and purging of a reaction gas, such as NH₃, O₂, Ar, and N₂, which are easy to diffuse and easy to purge. However, for a reaction gas, such as gasified H₂O, TMA, TiCl₄, PDMAT, etc., which are sticky, easy to condense coldly, and not easy to purge, when such the gas is transmitted by the above-mentioned gas distribution pipeline 6, residue may easily remain in the pipeline. Thus, a thin film may be formed due to chemical vapor deposition that occurs around an opening of the gas outlet pipeline 7. Since residue gas is more in the middle region of the gas distribution pipeline 6 compared to an edge region, the thin film deposited on the substrate may be thick at an edge and thick in the middle. FIG. 3 is a schematic diagram showing a thickness distribution of a film deposited by an existing gas distributor. It can be seen from FIG. 3 that the thickness uniformity of the thin film is poor.

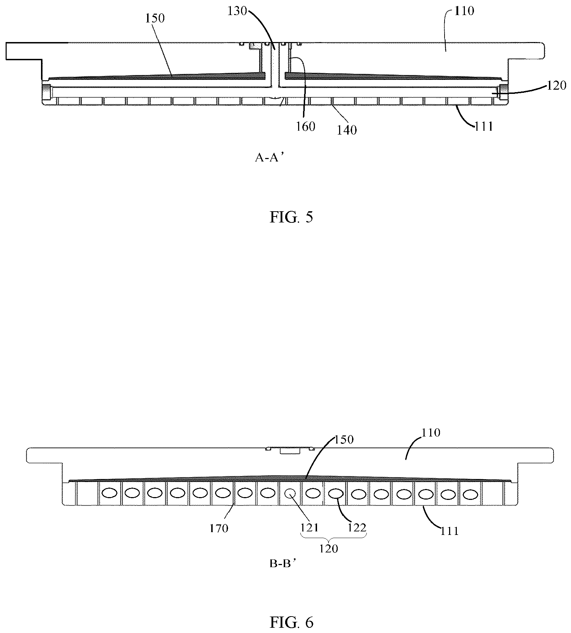

In a first aspect, embodiments of the present disclosure provide a gas distributor of a semiconductor apparatus. In some embodiments, the semiconductor apparatus may be a thin film deposition apparatus. FIG. 4 is a schematic top view of the gas distributor according to embodiments of the present disclosure. FIG. 5 is a schematic cross-section along line A-A' in FIG. 4. FIG. 6 is a schematic cross-section along line B-B' in FIG. 4. With reference to FIG. 4 to FIG. 6, the gas distributor includes a distributor body 110. The distributor body 110 includes a gas outlet end surface 111. A gas distribution pipeline group 120, a first gas inlet pipeline 130, and a plurality of first gas outlet pipelines 140 are arranged in the distributor body 110. A gas outlet end of the first gas inlet pipeline 130 is communicated with the gas inlet of the gas distribution pipeline group 120. Gas inlet ends of the plurality of first gas outlet pipelines 140 correspond to a plurality of gas outlets of the gas distribution pipeline group 120 in a one-to-one correspondence. In addition, the distributor body 110 further includes a gas distribution chamber 150 (a shaded area shown in FIG. 5 and FIG. 6), a second gas inlet pipeline 160, and a plurality of second gas outlet pipelines 170. The gas distribution chamber 150 is located above the gas distribution pipeline group 120 and is arranged around the first gas inlet pipeline 130. The gas outlet end of the second gas inlet pipeline 160 is communicated with the gas inlet of the gas distribution chamber 150. The gas inlet ends of the plurality of second gas outlet pipelines 170 are communicated with the plurality of gas outlets of the gas distribution chamber 150 in a one-to-one correspondence. The first gas outlet pipelines 140 and the second gas outlet pipelines 170 are arranged alternately. The gas outlet ends of the first gas outlet pipelines 140 and the second gas outlet pipelines 170 are located on the gas outlet end surface 111 of the distributor body 110. It should be understood that the gas distribution chamber 150 being located above the gas distribution pipeline group 120 may indicate that the gas distribution chamber 150 is located on a side of the gas distribution pipeline group 120 away from the gas outlet end surface 111.

The gas distribution chamber 150 may be an empty chamber surrounding the first gas inlet pipeline 130. The empty chamber may have a continuous integral structure. No structural member that affects gas flow may be arranged in the gas distribution chamber 150. Compared with the existing gas distribution pipeline, the gas distribution chamber may be more beneficial for gas diffusion, and the residue may not be easy to occur. For the reaction gas that is sticky, easy to condense coldly, and not easy to purge, the situation of the chemical vapor deposition occurring at the gas outlet due to the residue of such the gas in the pipeline may be prevented in the gas distribution chamber. Thus, the uniformity of the thin film deposited on the substrate may be improved.

In some embodiments, as shown in FIG. 5, the air inlet of the gas distribution chamber 150 is located at a position close to an inner peripheral edge of the gas distribution chamber 150. As such, the gas can diffuse from the position close to the inner peripheral edge of the gas distribution chamber 150 to an outer periphery edge.

The height of the gas distribution chamber 150 may gradually decrease from the inner peripheral edge of the first gas inlet pipeline 130 to the outer peripheral edge away from the first gas inlet pipeline 130, which can cause the volume of the gas distribution chamber to gradually decrease from the inside to the outside. Thus, a gas pressure in the gas distribution chamber can be ensured to be even, which helps to improve the gas diffusion rate. It should be understood that the height of the gas distribution chamber 150 may be a dimension of the gas distribution chamber 150 in an axial direction of the gas distribution chamber 150 or a vertical distance between a top surface and a bottom surface of the gas distribution chamber 150.

The gas distributor of embodiments of the present disclosure may be configured to output the reaction gas to the substrate in the reaction chamber. The structure of the gas distribution pipeline group 120 may be not specifically limited in embodiments of the present disclosure. For example, in order to quickly and uniformly transmit the reaction gas to positions of the reaction chamber, the gas distribution pipeline group 120 can adopt the same or similar network pipeline structure shown in FIG. 2. During thin film deposition, the reaction gas that is easy to diffuse and purge (e.g., NH₃, O₂, Ar, N₂, etc.) can be introduced from the first gas inlet pipeline 130 to the gas distribution pipeline group 120. After distributing by the gas distribution pipeline group 120, the reaction gas may be output from the first gas outlet pipelines 140.

The reaction gas(e.g., gasified H₂O, TMA, TiCl₄, PDMAT, etc.), that is relatively sticky, easy to condense, and difficult to purge, can be introduced into the gas distribution chamber 150 through the second gas inlet pipeline 160. After diffusing in the gas distribution chamber 150, such the reaction gas may be output from the second gas outlet pipelines 170. Compared to the gas distribution pipeline 6 in FIG. 2, the residue is not easy to occur since the gas distribution chamber 150 accommodates gas diffusion, which can prevent the situation of the chemical vapor deposition occurring at the gas outlet due to the residue in the pipeline of the gas in the gas distribution chamber. Thus, the gas in different regions of the gas distribution chamber 150 may evenly flow out from the second gas outlet pipelines 170 to improve the uniformity of the thin film deposited on the substrate. In addition, since the gas distribution chamber 150 is an integral empty chamber, no dead angle position may exist. Therefore, the residue of the reaction gas may not be easy to remain, which facilitates the cleaning of the gas distributor to improve the lifetime of the gas distributor.

In order to improve the uniformity of the gas output from the gas distributor, the first gas outlet pipelines 140 and the second gas outlet pipelines 170 may be evenly distributed in the distributor body 110. Thus, the gas outlet ends of the first gas outlet pipelines 140 and the second gas outlet pipelines 170 can be evenly arranged relative to the gas outlet end surface 111 of the distributor body. Moreover, an inner diameter of the first air outlet pipeline 140 and an inner diameter of the second air outlet pipeline 170 may be the same. Specifically, the inner diameters of the first air outlet pipelines 140 and the second air outlet pipelines 170 may range between 0.5 mm and 1 mm. Preferably, the inner diameters of the first air outlet pipelines 140 and the second air outlet pipelines 170 may be 1 mm.

In some embodiments, the height of the gas distribution chamber 150 at the inner peripheral edge of the gas distribution chamber 150 may range between 2 mm and 4 mm. The height of the gas distribution chamber 150 at the outer peripheral edge of the gas distribution chamber 150 may range between 0.5 mm and 1 mm. Preferably, the height of the gas distribution chamber 150 may be 3 mm at the inner peripheral edge and 1 mm at the outer peripheral edge. The bottom surface of the gas distribution chamber 150 may be substantially parallel to the gas outlet end surface 111 of the gas distributor. The vertical distance between the top surface and the bottom surface of the gas distribution chamber 150 may gradually decrease from the inner peripheral edge close to the first gas inlet pipeline 130 to the outer peripheral edge far away from the first gas inlet pipeline 130.

As shown in FIG. 4 and FIG. 5, in some embodiments, the second gas inlet pipeline 160 is an annular gas inlet pipeline arranged around the first gas inlet pipeline conduit 130. That is, a cross-section of the second gas inlet pipeline 160 that is parallel to the above-mentioned gas outlet end surface 111 is in an annular shape. Correspondingly, the gas inlet of the gas distribution chamber 150 may be an annular gas inlet. Thus, a distance that the gas entering the gas distribution chamber 150 from the annular gas inlet diffuses to the outer peripheral edge may be the same, which is beneficial to improve the uniformity of the gas flow.

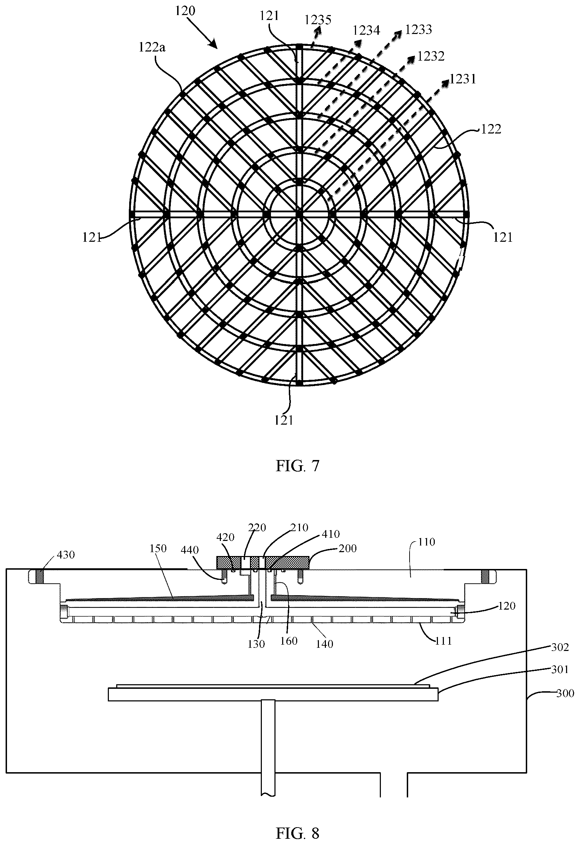

FIG. 7 is a schematic structural diagram of a gas distribution pipeline according to embodiments of the present disclosure. As shown in FIG. 4, FIG. 5, and FIG. 7, the gas distribution pipeline group 120 includes a plurality of main pipelines 121 and a plurality of sub-pipeline groups. The plurality of main pipelines 121 are radially arranged from the first gas inlet pipeline 130 in different directions away from the first gas inlet pipeline 130. For example, on a radial cross-section of the first gas inlet pipeline 130, the plurality of main pipelines 121 may be radially arranged in different radial directions of the first gas inlet pipeline 130 with an orthographic projection of an axis of the first gas inlet pipeline 130 as a center. Inner ends of the plurality of main pipelines 121 (i.e., an end close to the first gas inlet pipeline 130) may be communicated with the gas outlet of the first gas inlet pipeline. The gas that flows out from the first gas inlet pipleline 130 may diffuse in the main pipelines 121. For example, as shown in FIG. 7, a number of the main pipelines 121 is 4. Each two neighboring main pipelines 121 are perpendicular to each other. The sub-pipeline groups may be arranged in a one-to-one correspondence with the main pipelines 121. Each sub-pipeline group includes a plurality of sub-pipelines 122 arranged on two sides of the corresponding main pipeline 121 and having a predetermined included angle with the corresponding main pipeline 121. In each sub-pipeline group, the plurality of sub-pipelines on a same side of the main pipeline 121 may be arranged at intervals along an extension direction of the main pipeline 121. In some embodiments, the plurality of sub-pipelines 122 located on the same side of the main pipeline 121 in each sub-pipeline group may be parallel to each other. In addition, an inner end of each sub-pipeline 122 (i.e., an end close to the main pipeline 121) may be communicated with the main pipeline 121. The plurality of gas outlets of the gas distribution pipeline group 120 are gas outlets 122a arranged at the sub-pipeline 122, such as black circles in FIG. 7. The above-mentioned predetermined angle may be an acute angle such as 30°, 45°, or 60°.

In some embodiments, the sub-pipelines 122 located between any two neighboring main pipelines 121 may be parallel to each other. That is, any two neighboring main pipelines 121 may be referred to as a first main pipeline and a second main pipeline, respectively. The plurality of sub-pipelines of the sub-pipeline group corresponding to the first main pipeline that is located on a side close to the second main pipeline may be parallel to the plurality of sub-pipelines of the sub-pipeline group corresponding to the second main pipeline that is located on a side close to the first main pipeline. Thus, it is beneficial for the gas distribution pipeline group 120 to evenly output the reaction gas to the reaction chamber. The plurality of sub-pipelines 122 between the two neighboring main pipelines 121 may be, preferably, evenly arranged.

In some embodiments, the sub-pipelines 122 located on the two sides of the corresponding main pipeline 121 in the same sub-pipeline group may be symmetrically arranged. For example, the inner ends of the sub-pipelines 122 on different sides of the main pipeline 121 may be connected to a same position of the main pipeline 121 in a one-to-one correspondence, which is beneficial for the gas distribution pipeline group 120 to evenly output the reaction gas to the reaction chamber. Specifically, between two neighboring main pipelines 121, a distance between each neighboring two sub-pipelines 122 may be equal. The distance may be, for example, about 21 mm.

In addition, from the inner end of the main pipe 121 (the end close to the first gas inlet pipeline 130) to the outer end (the end far away from the first gas inlet pipeline 130), the inner diameter of the main pipeline 121 may gradually decrease. From the inner end (the end close to the main pipeline 121) to the outer end (the end far away from the main pipeline 121), the inner diameter of the sub-pipeline may 122 gradually decrease. Thus, the gas pressure in the gas distribution pipeline group 120 may be ensured to be balanced. Specifically, the inner diameter of the inner end of the main pipeline 121 may range from 2 to 4 mm. The diameter of the outer end of the main pipeline 121 may range from 1 to 2 mm. The inner diameter of the outer end of the sub-pipeline 122 may range from 1 to 2 mm. The inner diameter of the inner end of the sub-pipeline 122 may be set according to the inner diameter of the connection position of the main pipeline 121 and the sub-pipeline 121. Exemplarily, the inner diameter of the inner end of the main pipeline 121 may be 2.5 mm, and the inner diameter of the outer end of the main pipeline 121 and the inner diameter of the outer end of the sub-pipeline 122 may be both 1.5 mm.

In order to increase a gas diffusion speed in the gas distribution pipeline group 120 and improve purging efficiency, the gas distribution pipeline group 120 in embodiments of the present disclosure may further include at least one connection pipeline. The connection pipeline may be communicated with the main pipeline 121 and/or the sub-pipeline 122 that intersects with an extension trajectory of the connection pipeline.

Preferably, each connection pipeline may be an annular pipeline, and a plurality of annular pipelines may be included. For example, five annular pipelines 1231 to 1235 are shown in FIG. 7. On the radial cross-section of the first gas inlet pipeline, inner diameters of the orthographic projections of the five annular pipelines 1231 to 1235 are different. The five annular pipelines 1231 to 1235 may be concentrically arranged with the orthographic projection of the axis of the first gas inlet pipeline 130 as a center. Radial distances between the orthographic projections of any two neighboring annular pipelines may be equal to each other. In addition, the gas outlet 122a of each sub-pipeline 122 may be arranged at the position where the sub-pipeline 122 intersects the connection pipeline. As shown in FIG. 7, some gas outlets 122a may be located at a position where the sub-pipeline 122 intersects with the annular pipeline but does not intersect with the main pipeline 121. Some gas outlets 122a may be located at a position where the sub-pipeline 122 intersects with both the annular pipeline and the main pipeline 121.

Further, in some embodiments, on the radial cross-section of the first gas inlet pipeline 130, the radial distance between the orthographic projections of any two neighboring annular pipelines may be equal. Thus, the uniformity of the diffusion of the reaction gas in the gas distribution pipeline group 120 may be further improved.

It should be noted that, FIG. 7 schematically shows the situation where the five annular pipelines 1231 to 1235 are arranged. However, it should be understood that other numbers of annular pipelines can also be arranged. For example, only three annular pipelines of 1231, 1233, and 1235 in FIG. 7 may be arranged.

In a second aspect, embodiments of the present disclosure further provide a semiconductor apparatus. The semiconductor apparatus can be configured to perform thin film deposition. FIG. 8 is a schematic diagram of a semiconductor apparatus according to embodiments of the present disclosure. As shown in FIG. 8, the semiconductor apparatus includes a reaction chamber 300 and the gas distributor provided by the above-mentioned embodiments. The gas distributor may be fixed at a top of the reaction chamber 300 through a first fixing pin 430. The reaction chamber 300 further includes a base 301. The base 301 may be configured to carry a substrate 302 of the to-be-deposited thin film. The first gas inlet pipeline 130 of the gas distributor may be configured to be communicated with a first reaction gas supply device. A gas inlet of a second gas inlet pipeline 160 of the gas distributor may be configured to be communicated with a second reaction gas supply device. The first reaction gas supply device may be configured to supply a first reaction gas, and the second reaction gas supply device may be configured to supply the second reaction gas. A diffusion coefficient of the first reaction gas may be greater than a diffusion coefficient of the second reaction gas.

The diffusion coefficient may be a parameter indicating a gas diffusion degree. The larger the diffusion coefficient is, the easier the gas is to diffuse and purge. The smaller the diffusion coefficient is, the stickier, easier to condense, and more difficult to purge the gas.

In embodiments of the present disclosure, the first reaction gas that is easy to diffuse and hard to condense may be introduced into the gas distribution pipeline group 120, may quickly and uniformly diffuse in the gas distribution pipeline group 120, and then may be evenly output to various positions of the reaction chamber 300. No other shielding structure may be arranged in the gas distribution chamber 150. Therefore, by introducing the second reaction gas that is sticky, easy to condense, and difficult to purge into the gas distribution chamber 150, the diffusion efficiency of the second reaction gas in the gas distributor, which prevents the residue of the second reaction gas in the gas distributor. Thus, the uniformity of the thin film deposition may be improved. There is no dead angle in the gas distribution chamber 150. Thus, the gas distribution chamber 150 may be easy to clean, which can increase the application lifetime of the gas distributor.

In some embodiments, the semiconductor apparatus further includes a gas inlet block 200. The gas inlet block 200 may be fixedly arranged on a distributor body 110 through a second fixing pin 440. A first transmission channel 210 and a second transmission channel 220 may be further arranged in the gas inlet block 200. The first transmission channel 210 may be configured to communicate the first gas inlet pipeline 130 with the first reaction gas supply device. The second transmission channel 220 may be configured to communicate the second gas inlet pipeline 160 with the second reaction gas supply device.

A first sealing ring 410 and a second sealing ring 420 surrounding the first sealing ring 410 may be arranged between the gas inlet block 200 and the distributor body 110. The connection position between the first transmission channel 210 and the first gas inlet pipeline 130 may be located on an inner side of the first sealing ring (i.e., the connection position between the first transmission channel 210 and the first gas inlet pipeline 130 may be surrounded by the first sealing ring). A connection position between the second transmission channel 220 and the second gas inlet pipeline 160 may be located between the first sealing ring 410 and the second sealing ring 420. The first sealing ring 410 may prevent the first reaction gas and the second reaction gas from reacting at the connection position of the gas inlet block 200 and the distributor body 110. The second sealing ring 420 may isolate the second reaction gas from the outside atmosphere.

Taking the preparation of a TiN thin film as an example, a film forming process of the semiconductor apparatus may be introduced below. Among them, the TiN thin film may be formed through the reaction between the first reaction gas (e.g., NH₃) and the second reaction gas (Ti halide or Ti metal organic compound, such as TiCl₄). In connection with FIG. 5, FIG. 6, and FIG. 8, the film forming process is as follows.

Step 1: a relevant growth parameter is set. Specifically, the temperature of the reaction chamber 300 may range from 300 °C to 550 °C. The reaction pressure may be 0.5 to 10 torr. The purge gas used may be high-purity nitrogen or inert gas. The flow rate of the purge gas may be 10 to 5000 standard milliliters per minute.

Step 2: the second reaction gas (TiCl₄) is introduced into the reaction chamber 300. Specifically, the second reaction gas may be mixed with a diluent gas (e.g., high-purity nitrogen gas or inert gas) and then introduced into the gas distribution chamber 150. In the gas distribution chamber 150, the second reaction gas may disperse rapidly along with the dilution gas, then may be output from the second gas outlet pipeline 170 toward the substrate 302, and may be evenly distributed on the substrate 302. A vapor pressure of the second reaction gas supply device may be controlled to be 1 torr, and the gas flow of the second reaction gas may be selected from 20 to 500 standard milliliters per minute, preferably 20 to 80 standard milliliters per minute. The dilution gas flow may be selected from 400 to 5000 standard milliliters per minute, preferably 500-1000 standard milliliters per minute. The adsorption time of the second reaction gas on the substrate 302 may range from 0.05 to 1 s, preferably 0.1 to 0.5 s, to achieve saturated adsorption.

Meanwhile, the dilution gas may be introduced into the gas distribution pipeline group 120 through the first gas inlet pipeline 130. The dilution gas may quickly disperse in the gas distribution pipeline group 120 and may then be output from the first gas outlet pipeline 140. The flow rate of the dilution gas entering the first gas inlet pipeline 130 may range from 400 to 5000 standard milliliters per minute, preferably 3000 standard milliliters per minute. Introducing the dilution gas into the gas distribution pipeline group 120 may prevent the second reaction gas from entering into the gas distribution pipeline group 120 to form a residue.

Step 3: purging is performed on the residual gas in the gas distribution chamber 150. Specifically, on the basis of Step 2, the second reaction gas may be stopped being introduced into the gas distribution chamber 150, and the dilution gas may keep being introduced into the gas distribution chamber 150 and the gas distribution pipeline group 120. This state may last for 0.1 to 5 s, preferably 0.5 to 2 s. Then, the residual second reaction gas can be purged.

Step 4: the first reaction gas (NH₃) is introduced into the reaction chamber. Specifically, on the basis of the third step, after the first reaction gas is mixed with the dilution gas, the mixed gas may enter the gas distribution pipeline group 120 from the first gas inlet pipeline 130. In the gas distribution pipeline group 120, after the first reaction gas is rapidly dispersed with the dilution gas, the first reaction gas may be output from the first gas outlet pipeline 140 to be evenly distributed on the substrate 302. Meanwhile, the dilution gas may be kept being introduced into the gas distribution chamber 150. In this process, the flow rate of the first reaction gas may range from 500 to 5000 standard milliliters per minute, preferably from 2000 to 4000 standard milliliters per minute. The dilution gas flow rate may range from 400 to 5000 standard milliliters per minute, preferably from 500 to 1000 standard milliliters per minute. The adsorption time of the first reaction gas on the substrate 302 may range from 1 to 5 s, preferably from 1 to 3 s. Then, the saturation adsorption can be achieved.

Step 5: purging is performed on the residual gas in the gas distribution pipeline group 120. Specifically, on the basis of Step 4, the first reaction gas may be stopped being introduced into the gas distribution pipeline group 120. The dilution gas may be kept flowing into the gas distribution chamber 150 and the gas distribution pipeline group 120. This state may last for 0.1 to 5 s, preferably 0.5 to 1 s. Then, the residual first reaction gas in the gas distribution pipeline group 120 can be purged.

Step 6: whether the thin film deposition is completed is determined, if so, the process is ended, otherwise, return to Step 2.

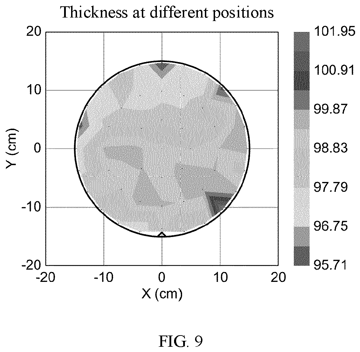

FIG. 9 is a schematic diagram of thickness distribution of a film deposited by a semiconductor apparatus according to embodiments of the present disclosure. A horizontal axis represents the abscissa of the positions of the thin film. The vertical axis represents the ordinate of the positions of the thin film. Different grayscales in the figure represent thicknesses of the film layers. It can be seen that, compared with the thickness distribution in FIG. 3, the thickness uniformity of the thin film formed in embodiments of the present disclosure is significantly improved.

In addition, experiments have shown that in the case where the gas distribution pipeline group 120 is not arranged with the annular pipeline, when introduction time of the first reaction gas (NH₃) in Step 4 may be 2 s in Step 4, and purge time in Step 5 is greater than or equal to 1 s, the uniformity of the deposited thin film may be about 1%. When the purge time in Step 5 is less than 1 s, the uniformity of the deposited thin film may be between 2% and 10%. When the gas distributor adopts the structure shown in FIG. 7, the introduction time of the first reaction gas (NH₃) is 2 s in Step 4, and the purge time in Step 5 is 0.7 s, the uniformity of the thin film may achieve 1%. It can be seen that by arranging the annular pipeline, the purge efficiency of the gas distribution pipeline may be improved by about 30%.

It can be understood that the above embodiments are only exemplary embodiments adopted to illustrate the principle of the present disclosure, but the present disclosure is not limited here. For those skilled in the art, without departing from the spirit and essence of the present disclosure, various modifications and improvements can be made, and these modifications and improvements are also regarded as the protection scope of the present disclosure.

## Claims

1. A gas distributor of a semiconductor apparatus comprising a distributor body, the distributor body including a gas outlet end surface, wherein the distributor body includes:
a gas distribution pipeline group, a first gas inlet pipeline, and a plurality of first gas outlet pipeline, wherein a gas outlet end of the first gas inlet pipeline is communicated with a gas inlet of the gas distribution pipeline group, and gas inlet ends of the plurality of first gas outlet pipelines are communicated to a plurality of gas outlets of the gas distribution pipeline group in a one-to-one correspondence; and
the distributor body further includes:
a gas distribution chamber, a second gas inlet pipeline, and a plurality of second gas outlet pipelines, wherein the gas distribution chamber is located above the gas distribution pipeline group, is arranged surrounding the first gas inlet pipeline, a height of the gas distribution chamber gradually decreases from an inner peripheral edge close to the first gas inlet pipeline to an outer peripheral edge away from the first gas inlet pipeline, a gas outlet of the second gas inlet pipeline is communicated with a gas inlet of the gas distribution chamber, gas inlets of the plurality of second gas outlet pipelines are communicated with the gas outlets of the gas distribution chamber in a one-to-one correspondence, the first outlet pipelines and the second outlet pipelines are staggeredly arranged, and the gas outlet ends of the first outlet pipelines and the second outlet pipelines are located on the gas outlet end surface of the distributor body.

2. The gas distributor according to claim 1, wherein the height of the gas distribution chamber at the inner peripheral edge is between 2 mm and 4 mm, and the height of the gas distribution chamber at the outer peripheral edge is between 0.5 mm and 1 mm.

3. The gas distributor according to claim 1, wherein the gas distribution pipeline group includes a plurality of main pipelines, the plurality of main pipelines being radially arranged from the first gas inlet pipeline in different directions away from the first gas inlet pipeline, and ends of the plurality of main pipelines close to the first gas inlet pipeline being communicated with a gas outlet end of the first gas inlet pipeline; and
the gas distribution pipeline group further includes a plurality of sub-pipeline groups, the sub-pipeline groups being arranged in a one-to-one correspondence with the main pipelines, each of the sub-pipeline groups including a plurality of sub-pipelines arranged on two sides of the corresponding main pipeline and at a predetermined included angle with the corresponding main pipeline, a plurality of sub-pipelines of each of the sub-pipeline groups located on a same side of the main pipeline being arranged at intervals along an extension direction of the main pipeline, an end of each of the sub-pipelines close to the main pipeline being communicated with the main pipeline, and a plurality of gas outlets of the gas distribution pipeline group being arranged at the plurality of sub-pipelines.

4. The gas distributor according to claim 3, wherein the gas distribution pipeline group further includes at least one connection pipeline; and
the connection pipeline is communicated with the main pipeline and/or the sub-pipeline intersecting with an extension trajectory of the connection pipeline.

5. The gas distributor according to claim 4, wherein, each connection pipeline is an annular pipeline, a plurality of annular pipelines are included, orthographic projections of the plurality of annular pipelines on a radial cross-section of the first gas inlet pipeline have different diameters and are concentrically arranged with an orthographic projection of an axis of the first gas inlet pipeline as a center, a radial distance between orthographic projections of any two neighboring annular pipelines are equal, and the gas outlet of each of the sub-pipelines is located at a position where the sub-pipeline intersects with the connection pipeline.

6. The gas distributor according to claim 3, wherein, from an end of the main pipeline close to the first gas inlet pipeline to the other end away from the first gas inlet pipeline, an inner diameter of the main pipeline gradually decreases, and from an end of the sub-pipeline close to the main pipeline to the other end away from the main pipeline, an inner diameter of the sub-pipeline gradually decreases.

7. The gas distributor according to claim 3, wherein all sub-pipelines located between any two neighboring main pipelines are parallel to each other.

8. The gas distributor according to claim 3, wherein the sub-pipelines located on the two sides of the main pipeline of a same sub-pipeline group are arranged symmetrically.

9. The gas distributor according to any one of claims 1 to 8, wherein the second gas inlet pipeline is an annular gas inlet pipeline arranged around the first gas inlet pipeline.

10. A semiconductor apparatus comprising the gas distributor according to any one of claims 1 to 9, wherein a gas inlet end of the first gas inlet pipeline is configured to be communicated with the first reaction gas supply device, a gas inlet end of the second gas inlet pipeline is configured to be communicated with the second reaction gas supply device, the first reaction gas supply device is configured to provide a first reaction gas, and the second reaction gas supply device is configured to provide a second reaction gas, and a diffusion coefficient of the first reaction gas is greater than a diffusion coefficient of the second reaction gas.

11. The semiconductor device according to claim 10, further comprising a gas inlet block arranged on the distributor body, wherein a first transmission channel and a second transmission channel are arranged in the gas inlet block, the first transmission channel is configured to communicate the first gas inlet pipeline with the first reaction gas supply device, and the second transmission channel is configured to communicate the second gas inlet pipeline with the second reaction gas supply device;
a first sealing ring and a second sealing ring surrounding the first sealing ring are arranged between the gas inlet block and the distributor body, a connection position between the first transmission channel and the first gas inlet pipeline is located on an inner side of the first sealing ring, and a connection position between the second transmission channel and the second gas inlet pipeline is located between the first sealing ring and the second sealing ring.
